# EUROPÄISCHE PATENTSCHRIFT

(11) **EP 4 151 865 B1**
(45) Veröffentlichungstag und Bekanntmachung des Hinweises auf die Patenterteilung: **11.02.2026**
(21) Anmeldenummer: 22206110.3
(22) Anmeldetag: 04.12.2018
(51) Int. Cl.: F16B 5/06, H05K 5/00, F16B 21/02

(54) **VERBINDERSYSTEM**
CONNECTOR SYSTEM
SYSTÈME DE CONNECTEUR

(43) Veröffentlichungstag der Anmeldung: 22.03.2023
(62) Teilanmeldung aus: 18210173.3
(73) Patentinhaber: Gustav Hensel GmbH & Co. KG, 57368 Lennestadt (DE)
(72) Erfinder: BAETZ, Marcus, 57399 Kirchhundem (DE)
(74) Vertreter: Brinkmann & Partner

(56) Entgegenhaltungen:
- EP-A1- 0 046 223
- DE-A1- 102012 018 694
- FR-A3- 2 540 946

## Beschreibung

Die vorliegende Erfindung betrifft ein Verbindersystem.

Bei einer Vielzahl von Montageaufgaben, insbesondere wenn es darum geht ebene Flächenbereiche miteinander zu verbinden, muss in der Regel auf kraftschlüssige Verbindungsmittel zurückgegriffen werden. Beispielsweise bei der Verbindung von Gehäusen, Brettern, Flächenelementen allgemeiner Art werden diese in aller Regel verschraubt, mit Bolzen durchsetzt oder endgültig verklebt und dergleichen.

Solche kraftschlüssigen Verbindungen sind aus dem Stand der Technik bekannt. Die EP 0 046 223 A1 offenbart beispielweise eine Spannverbindung für Rohre. Die Spannverbindung weist an einem ersten und einem benachbarten Rohr an den zu verbindenden Rohrenden außen jeweils zwei Flachstücke auf. Die Flachstücke wiederum weisen jeweils eine Bohrung auf, welche zueinander und jeweils mit einer Bohrung in einem Verbindungsteil fluchtend ausgebildet sind. Durch die Bohrung der Flachstücke und die Bohrung des Verbindungsteils wird ein Bolzen gesteckt, wobei das Verbindungsteil zwischen den Flachstücken angeordnet ist. Um ein Herausziehen des Bolzens zu verhindern, weist der Bolzen einen Nocken auf. Dieser Nocken wird beim Einstecken des Bolzens durch eine in den Bohrungen der Flachstücke und dem Verbindungsteil angeordnete Nut geführt. Es erfolgt also eine bestimmte Durchführung des Bolzens durch die zu verbindenden Elemente, nämlich die Flachstücke und das Verbindungsteil. Nachdem der Bolzen mit dem Nocken vollständig durch alle drei Elemente geführt ist und der Nocken nicht mehr in den Nuten der Elemente geführt ist, kann der Bolzen derart verdreht werden, dass der Nocken unterhalb des Flachstücks, durch das er zuletzt geführt worden ist, mit seiner diesem Flachstück zugewandten Fläche an diesem zur Anlage kommt und somit den Bolzen verriegelt.

Der Erfindung liegt die **Aufgabe** zugrunde, ein Verbindersystem anzugeben, welches einfach herstellbar, einfach betätigbar und wirksam zur Verbindung insbesondere von Gehäusen und sonstigen flächigen Elementen verwendet werden kann.

Zur technischen **Lösung** dieser Aufgabe wird ein Verbindersystem mit den Merkmalen des Anspruchs 1 vorgeschlagen. Weitere Vorteile und Merkmale ergeben sich aus den Unteransprüchen.

Gemäß der Erfindung umfasst das Verbindersystem zwei Lagerböcke, die jeweils eine Öffnung aufweisen, die relativ zu einer Oberfläche befestigbar und derart positionierbar sind, dass die Öffnungen zueinander fluchten. Solche Lagerböcke können einzeln ausgefertigt und beispielsweise Befestigungselemente wie Schraublöcher, Federstifte, Nutfedersysteme und dergleichen umfassen. Weiterhin umfasst das Verbindersystem einen Verbindungsbolzen, der die Lagerböcke verbindend in die zueinander fluchtenden Öffnungen einsetzbar ist. Dieser Verbindungsbolzen kann, nachdem die Lagerböcke entsprechend positioniert werden, in die Öffnungen eingeschoben und dort verrastet werden. Dabei ist beim erfindungsgemäßen Verbindungssystem am Verbindungsbolzen einerseits und wenigstens einer Öffnung andererseits ein zueinander passendes Paar aus einem Vorsprung und einer Ausnehmung ausgebildet. Erfindungsgemäß ist am Verbindungsbolzen ein Steg und in der Öffnung eine Nut ausgebildet. Es kann aber auch nicht-erfindungsgemäß umgekehrt sein, dass eine Langnut im Verbindungsbolzen einen in die Öffnung ragender Nocken aufnimmt. Der Verbindungsbolzen ist nur in einer Verdrehposition einschiebbar, da ansonsten der Vorsprung stört.

Gemäß einem Vorschlag der Erfindung sind die Lagerböcke von vorneherein miteinander verbunden. So können sie beispielsweise auf einer Basisplatte angeordnet sein oder durch sonstige Verbindungsmittel wie beispielsweise auch Gewindestangen und dergleichen miteinander verbunden sein. Die auf diese Weise vorbereitend verbundenen Lagerböcke können nun direkt mit dem Verbindungsbolzen bestückt werden. Werden die Lagerböcke beispielsweise durch Öffnungen von zu verbindenden Elementen gesteckt, so kann die Verbindung durch das Einschieben und Verdrehen des Verbindungsbolzens gesichert werden. Der Verbindungsbolzen kann verdreht werden, bis er gegen ein Anschlagelement stößt, welches gemäß der Erfindung vorgesehen ist. Weiterhin kann er in einer Position in einem Rastelement verrastet werden. Gemäß einem vorteilhaften Vorschlag der Erfindung sind Anschlagelement und Rastelement einstückig ausgebildet, indem beispielsweise an einem der Lagerböcke im Bereich der Öffnung ein Vorsprung ausgebildet ist, der mit einem Vorsprung am Verbindungsbolzen zusammenwirkt. Auch hier ist eine Umkehrung denkbar, dass ein Vorsprung im Bereich des Lagerbocks beispielsweise in eine Rastnut am Verbindungsbolzen einrastet und dergleichen.

Der Verbindungsbolzen weist gemäß der Erfindung einen stegartigen Vorsprung auf, der parallel zu einer Längsmittelachse des Verbindungsbolzens verläuft. Der Vorsprung ist vorzugsweise nicht über die volle Länge ausgeführt, sondern so, dass die Endbereiche des Verbindungsbolzen frei bleiben. Auf diese Weise können sie in den Öffnungen geführt werden, ohne dass der Vorsprung stört.

Dieser Vorsprung am Verbindungsbolzen kann mit dem Vorsprung am Lagerbock zum Zwecke des Anschlags und der Verrastung zusammenwirken. Weiterhin kann der Vorsprung am Verbindungsbolzen als Anschlagelement beim Einschieben in die Öffnungen verwendet werden, um so die Einschubtiefe zu begrenzen.

Der Vorsprung wirkt mit einer Nut in der Öffnung des Lagerbocks zusammen, in welchem der Verbindungsbolzen eingeschoben wird.

Der Verbindungsbolzen kann ein exzentrisch ausgeführtes Kopfstück aufweisen, welches durch eine Erweiterung in einem Kreissegment gebildet ist. Im Lagerbock kann eine entsprechende Öffnung ebenfalls durch eine exzentrische Erweiterung in einem Kreissegment ausgebildet sein, sodass beide Erweiterungen miteinander zusammenwirken. Werden die Lagerböcke durch Öffnungen in zu verbindenden Teilen hindurchgeführt, ragen die Öffnungen auf einer Seite zueinander fluchtend heraus. In diese Öffnungen lässt sich der Verbindungsbolzen einstecken und verrasten, sodass die Verbindung hergestellt ist. Gemäß einem vorteilhaften Vorschlag der Erfindung sind die Lagerböcke derart ausgeführt, dass der Verbindungsbolzen beim Verdrehen in einem bestimmungsgemäß in die Öffnungen der Lagerböcke eingesetzten Zustand gegen eine von wenigstens einem der Lagerböcke durchragte Oberfläche verspannt wird. Das heißt, die Oberfläche ragt in den Bereich der lichten Öffnung des Lagerbocks, sodass beim Verdrehen des Verbindungsbolzens, der abgeflacht ausgeführt sein kann, eine Verspannung erfolgt.

Mit der Erfindung wird ein einfach ausführbares Verbindersystem bereitgestellt, mit welchem erweiterte Möglichkeiten zur Verbindung von Gehäusen, flächigen Elementen und dergleichen durchgeführt werden können.

Weitere Vorteile und Merkmale der Erfindung ergeben sich aus der folgenden Beschreibung anhand der Figuren. Dabei zeigen:
- Fig. 1: eine perspektivische Darstellung eines Ausführungsbeispiels für ein erfindungsgemäßes Verbindersystem;
- Fig. 2: eine Darstellung gemäß Fig. 1 in einer anderen Verbindungsposition;
- Fig. 3: eine Darstellung gemäß Fig. 2 aus einer anderen Perspektive;
- Fig. 4: eine Darstellung des Verbinders gemäß Fig. 1 in einer Anwendungsposition;
- Fig. 5: eine vergrößerte Detaildraufsicht auf den Verbinder gemäß Fig. 4 und
- Fig. 6: eine Darstellung gemäß Fig. 4 in einer Verbindungsposition.

In den Figuren sind gleiche Elemente mit gleichen Bezugszeichen versehen.

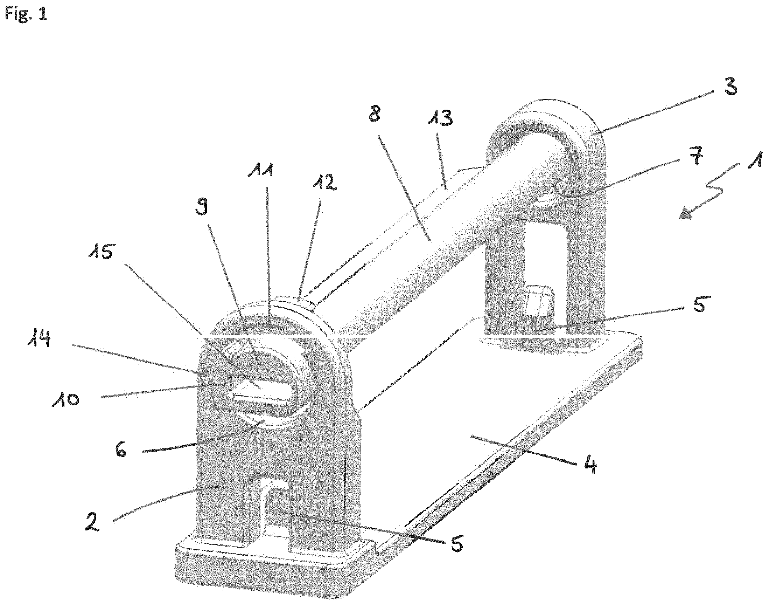

Die Figuren 1 bis 3 zeigen ein Ausführungsbeispiel für ein Verbindungssystem gemäß der Erfindung.

Das Verbindungssystem 1 umfasst einen Lagerbock 2 und einen Lagerbock 3. Im gezeigten Ausführungsbeispiel sind die Lagerböcke 2 und 3 auf einer Basisplatte 4 angeordnet. Die Basisplatte 4 weist im gezeigten Ausführungsbeispiel Befestigungselemente 5 in Form von Federhaken auf.

Der Lagerbock 2 hat die Öffnung 6, der Lagerbock 3 die Öffnung 7. Wie die Figuren zeigen, ist die Öffnung 7 im Wesentlichen kreisrund. Gleiches gilt auch für die Öffnung 6, die jedoch im Bereich 11 eine exzentrische Erweiterung im Frontbereich aufweist.

Weiterhin umfasst das Verbindungssystem einen Verbindungsbolzen 8, der im Bereich seiner Stirnfront 9 eine Erweiterung des Bolzens 10 aufweist, woraus sich eine Exzentrik ergibt. Die Erweiterung des Bolzens 10 läuft in der Erweiterung der Öffnung 11. Die Erweiterung der Öffnung ist nicht durchgehend im gezeigten Ausführungsbeispiel, sondern nur auf der Oberfläche ausgeführt.

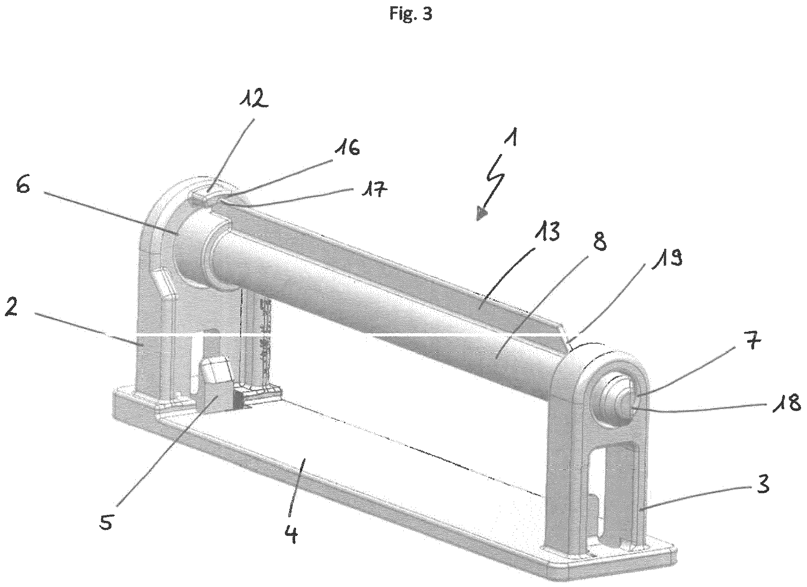

Wie insbesondere Figur 3 zeigt, ist ein Anschlag-/Rastnocken 12 auf der Rückseite des Lagerbocks 2 angeordnet. Auf diesem läuft der Federsteg 13 des Verbindungsbolzens 8 auf, in den er die Auflauframpe 16 entlangläuft, bis er in der Rastnut 17 einrastet.

Die Figuren zeigen, dass der Bolzenquerschnitt 18 abgeflacht ausgeführt ist. Der Federsteg 13 ist so lang ausgeführt, dass er eine hintere Anschlagkante 19 bildet, mit welcher der Bolzen gegen den Lagerbock 3 aufläuft.

Im gezeigten Ausführungsbeispiel ist die Basisplatte 4 so ausgeführt, dass die Höhen der Lagerböcke an eine vorgesehene Einbauposition angepasst sind. Die Öffnungen 6 und 7 fluchten und bieten somit eine Einführung für den Verbindungsbolzen 8.

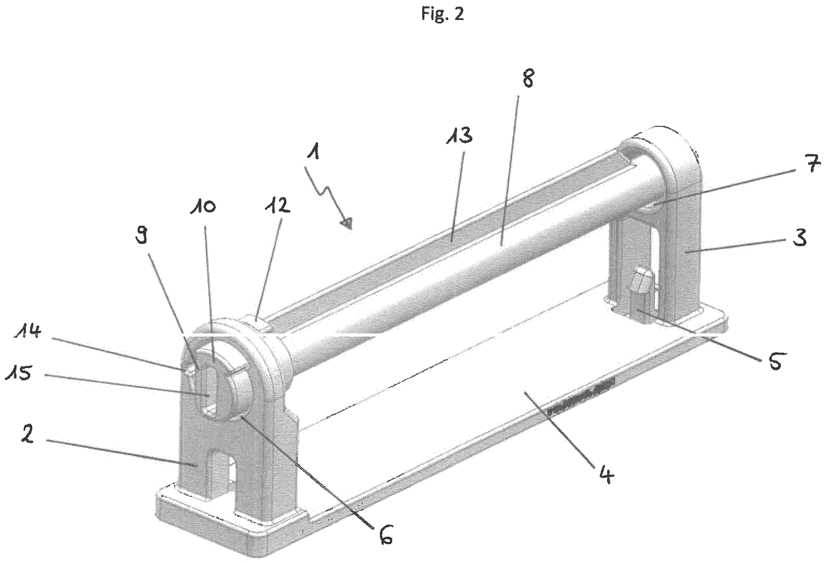

Es zeigt sich, dass der Verbindungsbolzen 8 nur in der in Figur 1 gezeigten Position überhaupt in den Lagerbock 2 einführbar und bis zum Lagerbock 3 durchführbar ist, da der Federsteg 13 in der Nut 14 des Lagerbocks 2 läuft. Erst in der in Figur 1 gezeigten Einsteckposition lässt sich der Verbindungsbolzen 8 verdrehen. Zu diesem Zweck kann in den Betätigungsschlitz 15 ein entsprechendes Werkzeug, beispielsweise ein Schraubenzieher eingesteckt werden. Bei der Verdrehung wird zum einen die im Bereich des Lagerbocks 2 liegende Stirnkante des Federstegs 13 über die Auflauframpe 16 in die Rastnut 17 des Anschlag- und Rastnocken 12 auflaufen, zum anderen die exzentrische Erweiterung 10 im Stirnflächenbereich des Verbindungsbolzens 8 in die exzentrische Erweiterung 11 im Lagerbock 2 einfahren, bis die in den Figuren 2 und 3 gezeigte Verrastposition erreicht ist.

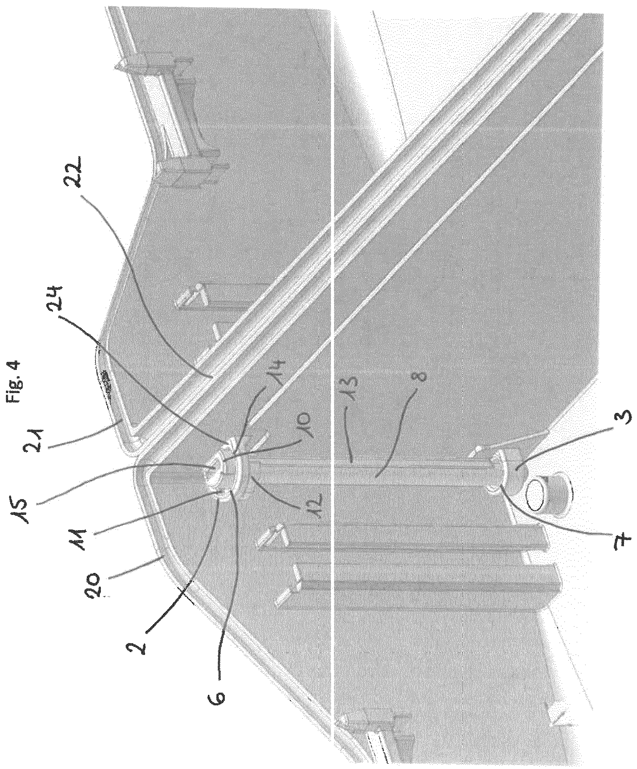

Die Figuren 4 bis 6 zeigen einen möglichen Einsatz des erfindungsgemäßen Verbindungssystems. Im gezeigten Ausführungsbeispiel sollen zwei Gehäuse 20 und 21 miteinander verbunden werden. Zu diesem Zweck liegen diese mit den Oberflächen im Verbindungsbereich 22 aufeinander. Die Oberflächen weisen geeignete Durchführungen 24 auf, sodass die Lagerböcke von einem Gehäuse 21 durch die Durchführungen 24 bis in das Innere des Gehäuses 20 hineinragen. Die Basisplatte 4 liegt dann an der inneren Oberfläche des Gehäuses 21 an.

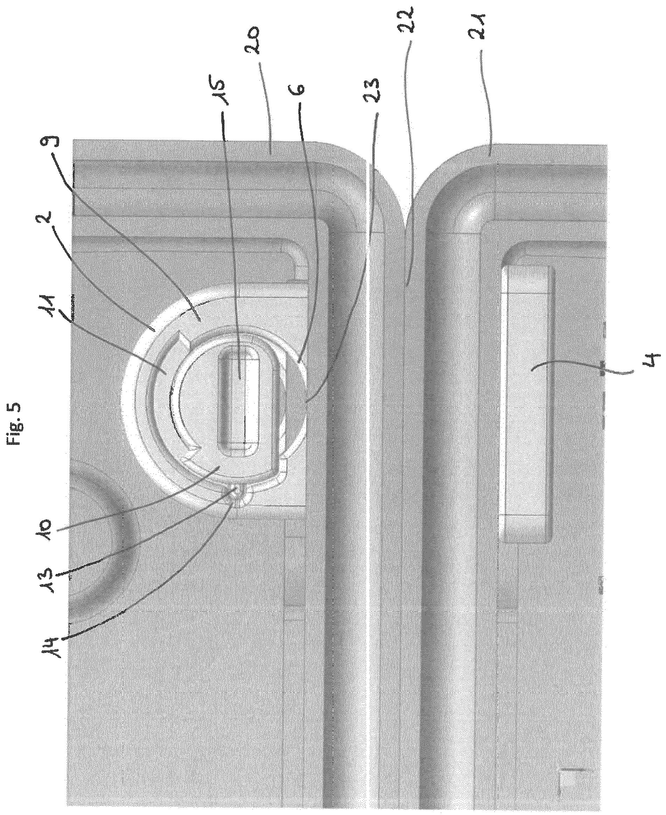

In die in das Gehäuse 20 hineinragenden Öffnungen der Lagerböcke 2 und 3 wird nunmehr der Verbindungsbolzen 8 eingeschoben. Zu diesem Zweck hat er zunächst die in den Figuren 4 und 5 gezeigte Position, bei welcher der Federsteg 13 in der Nut 14 geführt werden kann.

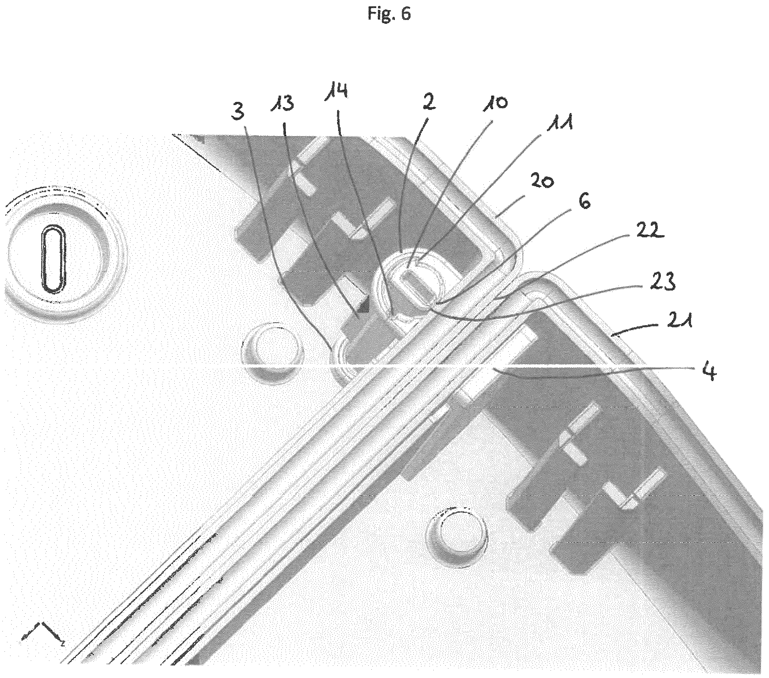

Die Figuren 5 und 6 zeigen, dass die Öffnung 6 in einem unteren Verspannungsbereich 23 zum Teil durch die Wandung des Gehäuses 20 abgedeckt ist. Wird nun der Verbindungsbolzen 8 betätigt, indem beispielsweise ein Schraubenzieher in den Betätigungsschlitz 15 eingesetzt und gedreht wird, erreicht der Verbindungsbolzen 8 die in Figur 6 gezeigte Position. Aufgrund der Exzentrizität verspannt sich nun der Bolzen im Verbindungsbereich 23 gegen die innere Oberfläche des Gehäuses 20. Dies erfolgt über die gesamte Länge des Verbindungsbolzens, sodass eine sehr gute Verbindung der beiden Gehäuse 20 und 21 auf einfachste Weise hergestellt ist.

Die beschriebenen Ausführungsbeispiele dienen nur der Erläuterung und sind nicht beschränkend.

### Bezugszeichen

- 1: Verbindungssystem
- 2: Lagerbock
- 3: Lagerbock
- 4: Basisplatte
- 5: Befestigungselement
- 6: Öffnung
- 7: Öffnung
- 8: Verbindungsbolzen
- 9: Stirnfront
- 10: Erweiterung Bolzen
- 11: Erweiterung Öffnung
- 12: Anschlag-/Rastnocken
- 13: Federsteg
- 14: Nut
- 15: Betätigungsschlitz
- 16: Auflauframpe
- 17: Rastnut
- 18: Bolzenquerschnitt
- 19: Anschlagkante
- 20: Gehäuse
- 21: Gehäuse
- 22: Verbindungsbereich
- 23: Verspannungsbereich
- 24: Durchführungen

## Patentansprüche

1. Verbindersystem, umfassend wenigstens zwei Lagerböcke (2, 3), die jeweils eine Öffnung (6, 7) aufweisen und die relativ zu einer Oberfläche befestigbar und derart positionierbar sind, dass die Öffnungen (6, 7) zueinander fluchten, und einem Verbindungsbolzen (8), der die Lagerböcke (2, 3) verbindend in die zueinander fluchtenden Öffnungen (6, 7) einsetzbar ist, wobei der Verbindungsbolzen (8) und wenigstens eine Öffnung (6) ein zueinander passendes Paar aus einem Vorsprung und einer Ausnehmung aufweisen, so dass der Verbindungsbolzen (8) nur in einer bestimmungsgemäßen Verdrehposition in diese Öffnung (6) einschiebbar ist, wobei der Vorsprung als Steg (13) ausgebildet ist, der parallel zu einer Längsmittelachse des Verbindungsbolzens (8) verläuft und dass die Öffnung (6) die als eine Nut (14) ausgebildete Ausnehmung aufweist, **dadurch gekennzeichnet, dass** der als Federsteg ausgebildete Steg (13) eine Länge aufweist, so dass der Steg (13) mit einer hinteren Anschlagkante (19) gegen den Lagerbock (3) aufläuft und der Steg (13) mit einer Stirnkante mit einem Anschlagelement und einem Rastelement am Lagerbock (2, 3) zum Zwecke des Anschlags und der Verrastung zusammenwirkt.

2. Verbindersystem nach Anspruch 1, **dadurch gekennzeichnet, dass** die Lagerböcke (2, 3) miteinander verbunden sind.

3. Verbindersystem nach Anspruch 2, **dadurch gekennzeichnet, dass** die Lagerböcke (2, 3) freistehend auf einer Basisplatte (4) angeordnet sind.

4. Verbindersystem nach Anspruch 3, **dadurch gekennzeichnet, dass** die Basisplatte (4) wenigstens ein Befestigungselement (5) aufweist.

5. Verbindersystem nach einem der vorhergehenden Ansprüche, **dadurch gekennzeichnet, dass** das Anschlagelement und das Rastelement einstückig als Anschlag- und Rastnocken (12) ausgebildet sind.

6. Verbindersystem nach Anspruch 1, **dadurch gekennzeichnet, dass** der Steg (13) die Endbereiche des Verbindungsbolzens (8) freilassend ausgebildet ist.

7. Verbindersystem nach Anspruch 5, **dadurch gekennzeichnet, dass** der Anschlag- und Rastnocken (12) eine Auflauframpe (16) und eine Rastnut (17) aufweist, wobei die Stirnkante des als Federsteg ausgebildeten Stegs (13) bei seiner Verdrehung über die Auflauframpe (16) in die Rastnut (17) aufläuft.

## Claims

1. Connector system, comprising at least two support blocks (2, 3), each of which has an opening (6, 7) and can be fixed relative to a surface and positioned in such a way that the openings (6, 7) align with each other, and a connecting bolt (8) that can be inserted into the mutually aligned openings (6, 7) so as to connect the bearing blocks (2, 3), wherein the connecting bolt (8) and at least one opening (6) have a matching pair consisting of a projection and a recess, so that the connecting bolt (8) can be inserted into said opening (6) only in an intended rotation position, wherein the projection is designed as a web (13) that runs parallel to a longitudinal center axis of the connecting bolt (8) and the opening (6) has the recess that is designed as a groove (14), **characterized in that** the web (13), which is designed as a spring web (13), has such a length that the rear stop edge (19) of the web (13) runs onto the support block (3) and the front edge of the web (13) interacts with a stop element and a locking element on the support block (2, 3) for the purpose of stopping and locking.

2. Connector system according to claim 1, **characterized in that** the support blocks (2, 3) are connected to each other.

3. Connector system according to claim 2, **characterized in that** the support blocks (2 3) are arranged free-standing on a base plate (4).

4. Connector system according to claim 3, **characterized in that** the base plate (4) comprises at least one fastening element (5).

5. Connector system according to any of the preceding claims, **characterized in that** the stop element and the locking element are integrally formed as a stop and locking cam (12).

6. Connector system according to claim 1, **characterized in that** the web (13) is designed to leave the end regions of the connecting bolt (8) free.

7. Connector system according to claim 5, **characterized in that** the stop and locking cam (12) has a run-up ramp (16) and a locking groove (17), wherein the front edge of the web (13) designed as a spring web runs into the locking groove (17) via the run-up ramp (16) on its rotation.

## Revendications

1. Système de connecteur, comprenant au moins deux blocs de support (2, 3), dont chacun présente une ouverture (6, 7) et peut être fixé par rapport à une surface et positionné de telle manière que les ouvertures (6, 7) soient alignées l'une avec l'autre, et un boulon de liaison (8) qui peut être inséré dans les ouvertures mutuellement alignées (6, 7) de manière à relier les blocs de support (2, 3), le boulon de liaison (8) et au moins une ouverture (6) comportant une paire complémentaire composée d'une saillie et d'un évidement, de sorte que le boulon de liaison (8) ne peut être inséré dans ladite ouverture (6) que dans une position de rotation prévue, dans lequel la saillie est conçue comme une nervure (13) qui s'étend parallèlement à un axe central longitudinal du boulon de liaison (8) et l'ouverture (6) comporte l'évidement qui est conçu comme une rainure (14), **caractérisé en ce que** la nervure (13), qui est conçue comme une nervure élastique (13), a une longueur telle que le bord d'arrêt arrière (19) de la nervure (13) échoue contre le bloc de support (3) et que le bord avant de la nervure (13) interagit avec un élément d'arrêt et un élément de verrouillage sur le bloc de support (2, 3) dans le but d'arrêter et de verrouiller.

2. Système de connecteur selon la revendication 1, **caractérisé en ce que** les blocs de support (2, 3) sont reliés entre eux.

3. Système de connecteur selon la revendication 2, **caractérisé en ce que** les blocs de support (2, 3) sont disposés de manière autoportante sur une plaque de base (4).

4. Système de connecteur selon la revendication 3, **caractérisé en ce que** la plaque de base (4) comprend au moins un élément de fixation (5).

5. Système de connecteur selon l'une quelconque des revendications précédentes, **caractérisé en ce que** l'élément d'arrêt et l'élément de verrouillage sont formés d'un seul tenant sous la forme d'une came d'arrêt et de verrouillage (12).

6. Système de connecteur selon la revendication 1, **caractérisé en ce que** la nervure (13) est conçue de manière à laisser libres les zones d'extrémité du boulon de liaison (8).

7. Système de connecteur selon la revendication 5, **caractérisé en ce que** la came d'arrêt et de verrouillage (12) comporte une rampe d'accès (16) et une rainure de verrouillage (17), le bord avant de la nervure (13) conçue comme une nervure à ressort montant dans la rainure de verrouillage (17) via la rampe d'accès (16) lors de sa rotation.
